# EUROPÄISCHE PATENTSCHRIFT

(11) **EP 1 093 083 B1**
(45) Veröffentlichungstag und Bekanntmachung des Hinweises auf die Patenterteilung: **11.03.2009**
(21) Anmeldenummer: 99120264.9
(22) Anmeldetag: 11.10.1999
(51) Int. Cl.: G06K 19/077

(54) **Chipkartenmodul**
Chip card module
Module de carte à puce

(43) Veröffentlichungstag der Anmeldung: 18.04.2001
(73) Patentinhaber: Infineon Technologies AG, 81669 München (DE)
(72) Erfinder: Heitzer, Josef, 93090 Bach (DE); Fries, Manfred, 94336 Hunderdorf (DE)
(74) Vertreter: Epping - Hermann - Fischer

(56) Entgegenhaltungen:
- EP-A- 0 390 487
- EP-A- 0 870 812
- DE-A- 4 326 816

## Beschreibung

Die Erfindung betrifft eine Leiterplatte mit einer Trägerschicht, auf der mit einem Polymerklebefilm wenigstens ein Halbleiterbauteil befestigt ist.

Im Stand der Technik sind Verfahren bekannt, Chipkartenmodule mit Halbleiterchips auszurüsten, bei denen Halbleiterchips auf Trägerbänder aus Epoxydharz montiert werden. Bei dieser Anwendung stellt ein Bereich des Trägerbands eine Trägerschicht dar, auf der mit einem Polymerklebefilm der Halbleiterchip aufgeklebt wird. Häufig wird der Polymerklebefilm anschließend in einem Erwärmungsschritt ausgehärtet. Bei diesen im Stand der Technik bekannten Verfahren ist es problematisch, daß die zum Aufkleben des Halbleiterchips auf das Trägerband angewendeten Prozeßschritte und Parameter durch aufwendige Versuche an die vorherrschenden Verhältnisse angepaßt werden müssen. Andernfalls ergibt sich keine gute Verbindung zwischen Halbleiterchip und Trägerband.

Es ist weiterhin bekannt, die Halbleiterchips auf sogenannte Halbleiterchipinseln zu montieren. Bei dieser Vorgehensweise ist problematisch, daß nur sehr kleine Halbleiterchips verwendbar sind.

In anderen Ausgestaltungen wurde versucht, die Ausheizzeit bei dem thermischen Aushärten des Polymerklebefilms zu verlängern, wobei es auch möglich ist, aufwendige Stufentemperaturprofile nachzufahren. Diese Ausgestaltungen haben sich in der Praxis wegen des dazu notwendigen Aufwands und der schweren Handhabbarkeit für Halbleiterchips aller Größen nicht bewährt.

Das Dokument DE 4 326 816 A1, das den nächsten Stand der Technik beschreibt, offenbart ein elektronisches Modul für Karten und Herstellung eines solchen Moduls. Insbesondere Figur 6 zeigt einen integrierten Schaltkreis 22 in eine Aussparung 32 eingeklebt und leitende Verbindungen 36 zwischen diesem Schaltkreis 22 und Kontaktflächen. Schließlich wird die Aussparung 32 mit einer Gussmasse vergossen (Spalte 5, Zeile 11).

Es weist aber keinerlei Merkmale auf, mit denen das Gasen der Trägerschicht bei Herstellung eines Moduls mittels eines zu erwärmenden Polymerklebefilm verhindert wird. Dieses Dokument weist weder eine Diffusionssperrschicht zwischen der Polymerklebeschicht und der Trägerschicht auf, noch wird ein Material aufgezeigt, was eine solche Diffusionssperrschicht darstellen könnte. Es ist auch keinerlei Hinweis darauf zu entnehmen, dass das Ausgasen zu Problemen führen könnte.

Es ist Aufgabe der Erfindung, eine Leiterplatte, ein Chipkartenmodul sowie ein Verfahren zum Herstellen einer Leiterplatte bzw. eines Chipkartenmoduls bereitzustellen, mit denen sich eine einfache und zuverlässige Herstellung ergibt.

Diese Aufgabe wird durch den Gegenstand der unabhängigen Ansprüche gelöst. Vorteilhafte Weiterbildungen ergeben sich aus den jeweiligen Unteransprüchen.

Gemäß der Erfindung ist zwischen dem Polymerklebefilm und der Trägerschicht wenigstens eine Diffusionssperrschicht vorgesehen. Dadurch wird sichergestellt, daß beim Erwärmen der Leiterplatte etwaige Gase, die aus der Trägerschicht austreten, nicht in den Polymerklebefilm eintreten können. Gemäß einem der Erfindung zugrundeliegenden Gedanken wird die mangelhafte Haftung, des mit den bekannten Verfahren auf der Trägerschicht befestigten Halbleiterbauteils, nämlich auf eine Beeinflussung des Polymerklebefilms durch Gase zurückgeführt, die besonders beim Erwärmen der Trägerschicht erzeugt werden. Diese Gase treten im Stand der Technik bei der Fertigstellung der Leiterplatte in den Polymerklebefilm ein und lösen dort Vernetzungen zwischen einzelnen Polymer-Molekülen auf. Im späteren Betrieb der Leiterplatte führt dies zu einem Versagen des Polymerklebefilms, wodurch die Leiterplatten zerstört werden.

Die Diffusionssperrschicht kann als dünne Metallschicht oder Polymerschicht mit Metallanteilen ausgebildet sein. Als Metall kommt insbesonders aufgedampftes oder chemisch abgeschiedenes Kupfer, Nickel oder Gold in Frage. Auch andere Stoffe, die Eigenschaften einer Diffusionssperre übernehmen können, kommen hierfür in Frage.

In Weiterbildung der Erfindung ist in der Trägerschicht eine Vertiefung zur Aufnahme der Diffusionssperrschicht vorzusehen, wobei die Diffusionssperrschicht auch in die Vertiefung einbringbar ist. Dadurch verbessert sich die Handhabung der erfindungsgemäßen Leiterplatte bei der Herstellung, wobei so eine Erhöhung der Moduldicke besonders einfach zu verhindern ist.

Eine obere Oberfläche der Diffusionssperrschicht schließt dabei vorteilhafterweise mit einer oberen Trägeroberfläche der Trägerschicht im wesentlichen bündig ab. Dadurch ergibt sich eine Leiterplatte, die keine zusätzliche Moduldicke aufweist, was deren Verwendung in den bekannten Herstellungsverfahren vereinfacht.

Die Diffusionssperrschicht kann zusätzlich zu den vorstehend beschriebenen Ausgestaltungen oder alternativ dazu auch als dünne Schicht auf die Trägerschicht aufgetragen werden. Dadurch ergibt sich eine besonders einfache und dennoch dünne Herstellung der erfindungsgemäßen Leiterplatte.

Weiterhin kann der Polymerklebefilm thermisch aktivierbar ausgestaltet sein. Gerade bei thermisch zu aktivierenden Polymerklebefilmen ergibt sich eine besonders gute Wirkung des erfindungsgemäßen Aufbaus einer Leiterplatte. Die Erfindung kann auch bei Polymerklebefilmen angewendet werden, die nicht thermisch aktiviert werden. Auch bei solchen Leiterplatten hat sich eine vorteilhafte Verwendung einer Diffusionssperrschicht herausgestellt, denn Trägerschichten, die nicht für eine thermische Aktivierung vorgesehen sind, gasen ebenfalls aus, so daß mit der Erfindung eine nachteilige Beeinflussung des Polymerklebefilms bei solchen Trägerschichten verhindert wird.

Die Diffusionsschicht füllt dabei den Bereich zwischen Polymerklebefilm und Trägerschicht vorteilhafterweise im wesentlichen vollständig aus, so daß keine größeren Gaseinschlüsse oder Lücken im Polymerklebefilm entstehen können.

Weiterhin ist im erfindungsgemäßen Aufbau eine elektrisch leitende Verbindung des Halbleiterchips mit wenigstens einer Leiterbahn auf der Trägerschicht vorgesehen. Hierzu ist wenigstens ein Durchbruch in die Trägerschicht eingebracht und wenigstens eine Leiterbahn ist auf der Unterseite der Trägerschicht aufgebracht. Sind wenigstens zwei Leiterbahnen auf der Unterseite der Trägerschicht aufgebracht, werden diese so angeordnet, daß die Leiterbahnen durch einen Spalt voneinander isoliert sind, um Kurzschlüsse zwischen den Leiterbahnen zu vermeiden. Die Leiterbahnen sind dabei jeweils so angeordnet, daß unterhalb eines Durchbruchs jeweils ein Kontaktbereich auf der betreffenden Leiterbahn ausgebildet ist, auf dem jeweils ein Anschlußkontakt vorgesehen ist. Auf der oberen Oberfläche des Halbleiterchips ist wenigstens ein Anschlußkontakt vorgesehen. Ausgehend von einem solchen Anschlußkontakt des Halbleiterchips kann auf einfache Weise zu jeweils einem Anschlußkontakt einer Leiterbahn ein elektrisch leitfähiger Verbindungsdraht vorgesehen werden.

Die Trägerschicht ist zumindest teilweise aus elektrisch isolierendem Kunststoff gefertigt, der Kurzschlüsse zwischen dem Halbleiterchip und den Leiterbahnen verhindert.

Weiterhin ist im erfindungsgemäßen Aufbau ein vorzugsweise aus Kunststoff gefertigtes Gehäuse vorgesehen, das die Trägerschicht und/oder den Halbleiterchip wenigstens teilweise umgibt, und das die Anordnung so vor Außeneinflüssen schützt.

Die Verwendung wenigstens einer erfindungsgemäßen Leiterplatte zur Herstellung eines Chipkartenmoduls bietet sich besonders bei der Herstellung von Chipkartenmodulen an, weil dort ähnliche Probleme wie bei der Herstellung von Leiterplatten auftreten.

Im Verfahren zur Herstellung einer Leiterplatte wird vorteilhafterweise eine Diffusionssperrschicht auf einer Trägerschicht der Leiterplatte vorgesehen, bevor eine Polymerklebeschicht auf die Trägerschicht aufgebracht wird.

In einem weiteren bevorzugten Verfahrensschritt wird eine Vertiefung zur Aufnahme der Diffusionssperrschicht in das Trägermaterial eingebracht, und zwar insbesondere durch ein Prägeverfahren. Die Verwendung eines Prägeverfahrens hat sich bei der Herstellung als vorteilhaft herausgestellt, da dabei wenig Prozeßzeit in Anspruch genommen wird.

Danach kann die Diffusionssperrschicht so in die Vertiefung eingebracht werden, daß eine obere Oberfläche der Diffusionssperrschicht mit einer oberen Trägeroberfläche der Trägerschicht im wesentlichen bündig abschließt. Diese Vorgehensweise bei der Herstellung erwies sich als eine besonders einfache Möglichkeit, eine Erhöhung der Moduldicke bei dem Aufbringen einer Diffusionssperrschicht zu vermeiden.

Die Diffusionssperrschicht kann als dünne Schicht auf die Trägerschicht aufgetragen werden, und zwar vorzugsweise in eine Vertiefung, falls eine solche vorgesehen ist. Dies erfolgt insbesondere mit einem Siebdruckverfahren oder mit einem Inkjetdruckverfahren. Diese Verfahren haben sich als besonders vorteilhaft erwiesen, da hierbei die Moduldicke im wesentlichen nicht erhöht wird. Außerdem braucht bei der Ausbildung der Diffusionssperrschicht als dünne Schicht keine besondere Vertiefung in die Trägerschicht eingebracht werden, was das Verfahren vereinfacht.

In einem weiteren Verfahrensschritt ist eine Erwärmung der Leiterplatte vorgesehen, bei der der Polymerklebefilm thermisch aktiviert und ausgehärtet wird. Dies erfolgt vorzugsweise mit einem Ofenheizprozeß, der sich als besonders schnelle und unkomplizierte Möglichkeit zum Aktivieren des Polymerklebefilms herausstellte.

Weiter ist in einem Verfahrensschritt das Umhüllen der Leiterplatte mit einem Gehäuse vorgesehen. Das Gehäuse umschließt dabei die Trägerschicht und/oder den Halbleiterchip wenigstens teilweise. Das Herstellen des Gehäuses erfolgt vorzugsweise durch ein Kunststoffgießverfahren. Dadurch kann die Leiterplatte auf einfache Weise vor äußeren Einflüssen geschützt werden.

Bei bekannten Chipkartenmodulen werden Halbleiterbauteile bzw. Halbleiterchips zum Teil auf Epoxyträgern bzw. auf Epoxy-Trägerbändern montiert. Bei der Aushärtung eines dazu verwendeten Polymerklebefilms bzw. Chipklebers gasen die Epoxy-Trägerbänder aus. Um eine optimale Klebeverbindung zu erreichen, müssen die dazu angewendeten Prozeßschritte und Prozeßparameter angepaßt werden.

Ein Problem besteht in der Aushärtung des Chipklebers. Es müssen entweder die Halbleiterchips auf Chipinseln montiert werden, was nur bei kleinen Halbleiterchips möglich ist, oder die Ausheizzeit muß verlängert werden und es muß mit aufwendigen Stufentemperaturprofilen gearbeitet werden.

Die Erfindung sieht insbesondere vor, auf den Epoxy-Trägerbändern im Bereich des Halbleiterchips eine Diffusionssperrschicht bzw. Diffusionssperre aufzubringen. Diese Diffusionssperre bewirkt, daß beim Aushärten des Chipklebers keine Ausgasungen der Epoxy-Trägerbänder in den Chipkleber eindringen können. Die Klebeverbindung wird dadurch so verbessert, daß sie mit einer Verbindung auf Kupferträgern vergleichbar ist. Die Aushärtezeit kann durch die Verwendung einer Diffusionssperre minimiert werden.

Die Diffusionssperre darf keine zusätzliche Moduldicke aufbauen. Dieses kann durch Schichten wie Kleber/Metallverbindungen usw. erreicht werden, die vorteilhaft mit Siebdruck aufgebracht werden können. Ein weiteres rationelles Verfahren ist das Inkjetdruckverfahren, wie es beim Tintenstrahldrucken verwendet wird.

Durch die Verwendung einer Diffusionssperre läßt sich außerdem eine Reduzierung der Ausheizzeit erreichen. Dies wirkt sich auf die Prozeßzeit aus, die dadurch ebenso reduziert wird.

Eine Diffusionsschicht wird besonders vorteilhaft in Zusammenhang mit stark gedünnten Halbleiterchips verwendet. Auch eine aufgebrachte Version weist nach dem Aushärten eine benötigte Festigkeit auf.

Die Erfindung ist anhand eines Ausführungsbeispiels näher veranschaulicht.

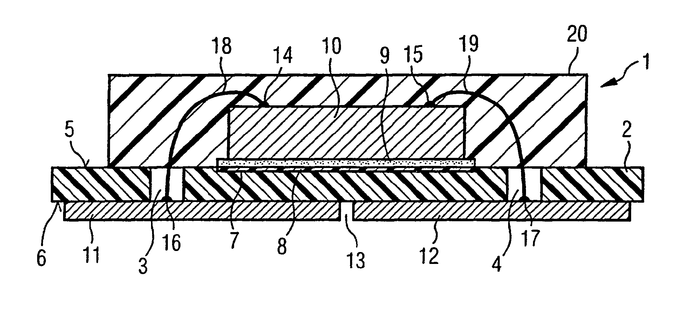

- Figur 1: zeigt einen Querschnitt durch ein erfindungsgemäßes Chipkartenmodul 1.

Figur 1 zeigt ein erfindungsgemäßes Chipkartenmodul 1 im Querschnitt. Das Chipkartenmodul 1 hat einen Epoxyträger 2, der mit zahlreichen Durchbrüchen versehen ist, von denen hier nur zwei Durchbrüche 3, 4 sichtbar sind. Die Durchbrüche 3, 4 verlaufen zwischen einer oberen Trägeroberfläche 5 und einer unteren Trägeroberfläche 6 des Epoxyträgers 2.

Im Bereich zwischen den Durchbrüchen 3, 4 ist in die obere Trägeroberfläche 5 eine Vertiefung 7 eingebracht, die in der Draufsicht auf die obere Trägeroberfläche 5 eine im wesentlichen rechteckige Form hat.

Die Vertiefung 7 ist mit einer Diffusionssperrschicht 8 aufgefüllt, und zwar so, daß die obere Oberfläche der Diffusionssperrschicht 8 mit der oberen Trägeroberfläche 5 im wesentlichen abschließt.

Auf der Diffusionssperrschicht 8 ist ein Polymerklebefilm 9 so aufgebracht, daß im wesentlichen der gesamte Bereich über der Diffusionssperrschicht 8 abgedeckt ist. Der Polymerklebefilm 9 ist dabei so aufgebracht, daß im wesentlichen kein Kontakt der oberen Trägeroberfläche 5 mit dem Polymerklebefilm 9 besteht.

Auf dem Polymerklebefilm 9 ist ein in der Draufsicht im wesentlichen rechteckiges Halbleiterbauteil 10 vorgesehen. Die untere Oberfläche des Halbleiterbauteils 10 liegt dabei auf dem Polymerklebefilm 9 auf und wird durch diesen gehalten.

Auf die untere Trägeroberfläche 6 ist eine erste Leiterbahn 11 sowie eine zweite Leiterbahn 12 aufgebracht. Die Leiterbahnen 11, 12 sind dabei so auf dem Epoxyträger 2 angeordnet, daß zwischen deren Enden ein Spalt 13 zu deren elektrischen Isolierung gebildet ist. Dabei verläuft je ein Kontaktbereich der Leiterbahnen 11, 12 im Bereich unterhalb je eines Durchbruchs 3, 4.

Das Halbleiterbauteil 10 weist auf seiner Oberseite einen ersten Anschlußkontakt 14 und einen zweiten Anschlußkontakt 15 auf. Ein erster Verbindungsdraht 18 verläuft zwischen dem Anschlußkontakt 14 und dem Anschlußkontakt 16 auf der oberen Oberfläche der Leiterbahn 11. Ein zweiter Verbindungsdraht 19 verläuft zwischen den Anschlußkontakt 15 und dem Anschlußkontakt 17 auf der oberen Oberfläche der Leiterbahn 12.

Auf dem Epoxyträger 2 ist ein in der Draufsicht im wesentlichen rechteckiges Gehäuse 20 aus Kunststoff aufgebracht. Das Gehäuse 20 ist auf der oberen Trägeroberfläche 5 befestigt und bildet den oberen Bereich des Chipkartenmoduls 1. Das Gehäuse 20 umschließt dabei das Halbleiterbauteil 10 sowie die Durchbrüche 3, 4 und die Verbindungsdrähte 18, 19.

Zur Herstellung des in Figur 1 gezeigten Chipkartenmoduls 1 wird wie folgt vorgegangen. In einem ersten Verfahrensschritt werden die Durchbrüche 3, 4 in den Epoxyträger 2 eingebracht. Dies erfolgt beispielsweise durch ein Ätzverfahren oder durch ein Fräsverfahren.

Anschließend werden die Leiterbahnen 11, 12 an der unteren Trägeroberfläche 6 angebracht, und zwar so, daß der Spalt 13 zur Isolierung der Leiterbahnen 11, 12 voneinander bestehen bleibt.

Im weiteren wird auf der oberen Trägeroberfläche 5 im Bereich zwischen den Durchbrüchen 3, 4 die Vertiefung 7 eingebracht. Dies erfolgt beispielsweise durch ein Ätzverfahren oder durch ein Prägeverfahren.

In einem weiteren Verfahrensschritt wird in die Vertiefung 7 die Diffusionssperrschicht 8 eingebracht. Diese wird so aufgetragen, daß die obere Trägeroberfläche 5 mit der oberen Oberfläche der Diffusionssperrschicht 8 im wesentlichen abschließt. Dies erfolgt beispielsweise durch ein Siebdruckverfahren oder durch ein Inkjetverfahren.

Anschließend wird über der Diffusionssperrschicht 8 ein Polymerklebefilm 9 aufgebracht. Der Polymerklebefilm 9 ist durch einen Heizprozeß thermisch aktivierbar.

In einem weiteren Verfahrensschritt wird das Halbleiterbauteil 10 auf dem Polymerklebefilm 9 mittig positioniert und aufgepreßt, bis es die in Figur 1 gezeigte Lage erreicht und die untere Oberfläche des Halbleiterbauteils 10 bündig aufliegt.

In einem nachfolgendem Heizprozeß wird der Polymerklebefilm 9 aktiviert und ausgehärtet. Die Diffusionssperrschicht 8 verhindert dabei, daß im Epoxyträger 2 entstehenden Gase in den Polymerklebefilm 9 eindringen. So wird eine unerwünschte Veränderung der Materialeigenschaften des Polymerklebefilms 9 während des Heizprozesses verhindert.

Anschließend werden ausgehend von den Anschlußkontakten 14, 15 des Halbleiterbauteils 10 Verbindungsdrähte 18, 19 zu den Anschlußkontakten 16, 17 auf den oberen Oberflächen der Leiterbahnen 11, 12 eingebracht. Die Verbindungsdrähte 18, 19 stellen somit eine elektrisch leitende Verbindung des Halbleiterbauteils 10 mit den Leiterbahnen 11, 12 her.

Auf der oberen Trägeroberfläche 5 wird in einem weiteren Verfahrensschritt ein Gehäuse 20 aufgebracht, das das Halbleiterbauteil 10 und die Verbindungsdrähte umgibt.

## Patentansprüche

1. Leiterplatte mit einer mindestens eine Leiterbahn aufweisende Trägerschicht (2), auf der mit einem Polymerklebefilm (9) wenigstens ein Halbleiterbauteil (10) befestigt ist, **dadurch gekennzeichnet, daß** zwischen dem Polymerklebefilm (9) und der Trägerschicht (2) wenigstens eine Diffusionssperrschicht (8) vorgesehen ist.

2. Leiterplatte nach Anspruch 1,
**dadurch gekennzeichnet, daß**
in der Trägerschicht (2) eine Vertiefung (7) zur Aufnahme der Diffusionssperrschicht (8) vorgesehen ist.

3. Leiterplatte nach Anspruch 2,
**dadurch gekennzeichnet, daß**
die Diffusionssperrschicht (8) in die Vertiefung (7) eingebracht ist.

4. Leiterplatte nach Anspruch 2 oder Anspruch 3,
**dadurch gekennzeichnet, daß**
eine obere Oberfläche der Diffusionssperrschicht (8) mit einer oberen Trägeroberfläche (5) der Trägerschicht im wesentlichen bündig abschließt.

5. Leiterplatte nach einem der vorhergehenden Ansprüchen,
**dadurch gekennzeichnet, daß**
die Diffusionssperrschicht (8) als dünne Schicht auf der Trägerschicht (2) aufgetragen ist.

6. Leiterplatte nach einem der vorhergehenden Ansprüchen,
**dadurch gekennzeichnet, daß**
der Polymerklebefilm (9) thermisch aktivierbar ist.

7. Leiterplatte nach einem der vorhergehenden Ansprüche,
**dadurch gekennzeichnet, daß**
die Diffusionssperrschicht (8) den Bereich zwischen Polymerklebefilm (9) und Trägerschicht (2) im wesentlichen vollständig ausfüllt.

8. Leiterplatte nach Anspruch 1,
**dadurch gekennzeichnet, daß**
die Trägerschicht (2) isolierenden Kunststoff aufweist und wenigstens ein Durchbruch (3, 4) vorgesehen ist.

9. Leiterplatte nach Anspruch 1 oder Anspruch 8,
**dadurch gekennzeichnet, daß**
an einer Unterseite der Trägerschicht (2) wenigstens zwei Leiterbahnen (11, 12) vorgesehen sind, die so angeordnet sind, daß zwischen ihnen wenigstens ein Spalt (13) zu deren galvanischer Trennung ausgebildet ist.

10. Leiterplatte nach Anspruch 9,
**dadurch gekennzeichnet, daß**
wenigstens eine Leiterbahn (11, 12) wenigstens teilweise unterhalb eines Durchbruchs (3, 4) verläuft, wobei unterhalb des Durchbruchs (3, 4) ein Anschlußkontakt (16, 17) auf der Leiterbahn vorgesehen ist.

11. Leiterplatte nach Anspruch 1,
**dadurch gekennzeichnet, daß**
auf einer Oberseite des Halbleiterbauteils (10) wenigstens ein Anschlußkontakt (14, 15) vorgesehen ist.

12. Leiterplatte nach Anspruch 10 und Anspruch 11,
**dadurch gekennzeichnet, daß**
zwischen je einem Anschlußkontakt (14, 15) des Halbleiterbauteils (10) und je einem Anschlußkontakt (16, 17) einer Leiterbahn (11, 12) ein Verbindungsdraht (18, 19) vorgesehen ist.

13. Leiterplatte nach einem der vorhergehenden Ansprüchen,
**dadurch gekennzeichnet, daß**
ein Gehäuse (20) vorgesehen ist, das die Trägerschicht (2) und/oder das Halbleiterbauteil (10) wenigstens teilweise umgibt.

14. Chipkartenmodul (1) mit wenigstens einer Leiterplatte nach einer der vorhergehenden Ansprüche.

15. Verfahren zur Herstellung einer Leiterplatte, das die folgenden Schritte aufweist:
- Vorsehen einer mindestens eine Leiterbahn aufweisende Trägerschicht (2),
- Aufbringen einer Diffusionssperrschicht (8) auf die Trägerschicht (2)
- Aufbringen eines Polymerklebefilms (9) auf die Diffusionssperrschicht (8)
- Aufbringen eines Halbleiterbauteils (10) auf den Polymerklebefilm (9),
- Aushärten des Polymerklebefilms (9).

16. Verfahren nach Anspruch 15,
**dadurch gekennzeichnet, daß**
der Schritt des Vorsehens einer Vertiefung (7) zur Aufnahme der Diffusionssperrschicht (8) vorgesehen ist, und zwar insbesondere mit einem Prägeverfahren.

17. Verfahren nach Anspruch 16,
**dadurch gekennzeichnet, daß**
die Diffusionssperrschicht (8) so in die Vertiefung (7) eingebracht wird, daß eine obere Oberfläche der Diffusionssperrschicht (8) mit einer oberen Trägeroberfläche (5) der Trägerschicht (2) im wesentlichen bündig abschließt.

18. Verfahren nach einem der Ansprüche 15 bis 17,
**dadurch gekennzeichnet, daß**
die Diffusionssperrschicht (8) als dünne Schicht auf der Trägerschicht (2) aufgetragen wird.

19. Verfahren nach einem der Ansprüche 15 bis 18,
**dadurch gekennzeichnet, daß**
die Diffusionssperrschicht (8) durch ein Siebdruckverfahren oder durch ein Inkjetdruckverfahren aufgetragen wird.

20. Verfahren nach einem der Ansprüche 15 bis 19,
**dadurch gekennzeichnet, daß**
der Polymerklebefilm (9) durch einen Heizprozeß aktiviert wird.

21. Verfahren nach einem der Ansprüche 15 bis 20,
**dadurch gekennzeichnet, daß**
ein die Trägerschicht (2) und/oder das Halbleiterbauteil (10) wenigstens teilweise umgebendes Gehäuse (20) vorgesehen ist, und zwar insbesondere mit einem Kunststoffgießverfahren.

## Claims

1. Printed circuit board comprising a carrier layer (2) having at least one conductor track, at least one semiconductor component (10) being fixed on said carrier layer by means of a polymer adhesive film (9), **characterized in that** at least one diffusion barrier layer (8) is provided between the polymer adhesive film (9) and the carrier layer (2).

2. Printed circuit board according to Claim 1,
**characterized in that**
a depression (7) for receiving the diffusion barrier layer (8) is provided in the carrier layer (2).

3. Printed circuit board according to Claim 2,
**characterized in that**
the diffusion barrier layer (8) is introduced into the depression (7).

4. Printed circuit board according to Claim 2 or Claim 3,
**characterized in that**
an upper surface of the diffusion barrier layer (8) terminates substantially flush with an upper carrier surface (5) of the carrier layer.

5. Printed circuit board according to any of the preceding claims,
**characterized in that**
the diffusion barrier layer (8) is applied as a thin layer on the carrier layer (2).

6. Printed circuit board according to any of the preceding claims,
**characterized in that**
the polymer adhesive film (9) can be activated thermally.

7. Printed circuit board according to any of the preceding claims,
**characterized in that**
the diffusion barrier layer (8) substantially completely fills the region between polymer adhesive film (9) and carrier layer (2).

8. Printed circuit board according to Claim 1,
**characterized in that**
the carrier layer (2) comprises insulating plastic and at least one perforation (3, 4) is provided.

9. Printed circuit board according to Claim 1 or Claim 8,
**characterized in that**
at least two conductor tracks (11, 12) are provided at an underside of the carrier layer (2), said conductor tracks being arranged such that at least one gap (13) for their direct isolation is formed between them.

10. Printed circuit board according to Claim 9,
**characterized in that**
at least one conductor track (11, 12) runs at least partly below a perforation (3, 4), a connection contact (16, 17) being provided on the conductor track below the perforation (3, 4).

11. Printed circuit board according to Claim 1,
**characterized in that**
at least one connection contact (14, 15) is provided on a top side of the semiconductor component (10).

12. Printed circuit board according to Claim 10 and Claim 11,
**characterized in that**
a connecting wire (18, 19) is provided between a respective connection contact (14, 15) of the semiconductor component (10) and a respective connection contact (16, 17) of a conductor track (11, 12).

13. Printed circuit board according to any of the preceding claims,
**characterized in that**
a housing (20) is provided, which at least partly surrounds the carrier layer (2) and/or the semiconductor component (10).

14. Smart card module (1) comprising at least one printed circuit board according to any of the preceding claims.

15. Method for producing a printed circuit board, comprising the following steps:
- providing a carrier layer (2) having at least one conductor track,
- applying a diffusion barrier layer (8) to the carrier layer (2),
- applying a polymer adhesive film (9) to the diffusion barrier layer (8),
- applying a semiconductor component (10) to the polymer adhesive film (9),
- curing the polymer adhesive film (9).

16. Method according to Claim 15,
**characterized in that**
the step of providing a depression (7) for receiving the diffusion barrier layer (8) is provided, to be precise in particular by means of an embossing method.

17. Method according to Claim 16,
**characterized in that**
the diffusion barrier layer (8) is introduced into the depression (7) such that an upper surface of the diffusion barrier layer (8) terminates substantially flush with an upper carrier surface (5) of the carrier layer (2).

18. Method according to any of Claims 15 to 17,
**characterized in that**
the diffusion barrier layer (8) is applied as a thin layer on the carrier layer (2).

19. Method according to any of Claims 15 to 18,
**characterized in that**
the diffusion barrier layer (8) is applied by a screen printing method or by an inkjet printing method.

20. Method according to any of Claims 15 to 19,
**characterized in that**
the polymer adhesive film (9) is activated by a heating process.

21. Method according to any of Claims 15 to 20,
**characterized in that**
a housing (20) that at least partly surrounds the carrier layer (2) and/or the semiconductor component (10) is provided, to be precise in particular by means of a plastic moulding method.

## Revendications

1. Plaquette à circuits imprimés comprenant une couche (2) de support, qui a au moins une piste conductrice et sur laquelle au moins un composant (10) à semi-conducteurs est fixé par un film (9) adhésif polymère, **caractérisée en ce qu'**il est prévu au moins une couche (8) d'arrêt de la diffusion entre le film (9) adhésif polymère et la couche (2) de support.

2. Plaquette à circuits imprimés suivant la revendication 1,
**caractérisée en ce que**
il est prévu, dans la couche (2) de support, une cavité (7) de réception de la couche (8) d'arrêt de la diffusion.

3. Plaquette à circuits imprimés suivant la revendication 2,
**caractérisée en ce que**
la couche (8) d'arrêt de la diffusion est mise dans la cavité (7).

4. Plaquette à circuits imprimés suivant la revendication 2 ou 3,
**caractérisée en ce que**
une surface supérieure de la couche (8) d'arrêt de la diffusion est sensiblement à affleurement avec une surface (5) supérieure de support de la couche de support.

5. Plaquette à circuits imprimés suivant l'une des revendications précédentes,
**caractérisée en ce que**
la couche (8) d'arrêt de la diffusion est déposée sous la forme d'une couche mince sur la couche (2) de support.

6. Plaquette à circuits imprimés suivant l'une des revendications précédentes,
**caractérisée en ce que**
le film (9) adhésif polymère peut être activé thermiquement.

7. Plaquette à circuits imprimés suivant l'une des revendications précédentes,
**caractérisée en ce que**
la couche (8) d'arrêt de la diffusion remplit sensiblement complètement la partie comprise entre le film (9) adhésif polymère et la couche (2) de support.

8. Plaquette à circuits imprimés suivant la revendication 1,
**caractérisée en ce que**
la couche (2) de support a une matière isolante et il est prévu au moins une traversée (3, 4).

9. Plaquette à circuits imprimés suivant la revendication 1 ou 8,
**caractérisée en ce qu'**il
est prévu sur une face inférieure de la couche (2) de support, au moins deux pistes (11, 12) conductrices disposées de façon à former entre elles au moins un intervalle (13) pour leur séparation galvanique.

10. Plaquette à circuits imprimés suivant la revendication 9,
**caractérisée en ce que**
au moins une piste (11, 12) conductrice s'étend au moins en partie en-dessous d'une traversée (3, 4), un contact (16, 17) de borne étant prévu sur la piste conductrice en-dessous de la traversée (3, 4).

11. Plaquette à circuits imprimés suivant la revendication 1,
**caractérisée en ce qu'**il
est prévu au moins un contact (14, 15) de borne sur une face supérieure du composant (10) à semi-conducteurs.

12. Plaquette à circuits imprimés suivant les revendications 10 et 11,
**caractérisée en ce qu'**il
est prévu un fil (18, 19) de liaison entre respectivement un contact (14, 15) de borne du composant (10) à semi-conducteurs et respectivement un contact (16, 17) de borne d'une piste (11, 12) conductrice.

13. Plaquette à circuits imprimés suivant l'une des revendications précédentes,
**caractérisée en ce qu'**il
est prévu un boîtier (20) qui entoure au moins en partie la couche (2) de support et/ou le composant (10) à semi-conducteurs.

14. Module (1) de carte à puce ayant au moins une plaquette à circuits imprimés suivant l'une des revendications précédentes.

15. Procédé de production d'une plaquette à circuits imprimés qui a les stades suivants :
- on prévoit une couche (2) de support ayant au moins une piste conductrice,
- on dépose une couche (8) d'arrêt de la diffusion sur la couche (2) de support,
- on dépose un film (9) adhésif polymère sur la couche (8) d'arrêt de la diffusion,
- on dépose un composant (10) à semi-conducteurs sur le film (9) adhésif polymère,
- on durcit le film (9) adhésif polymère.

16. Procédé suivant la revendication 15,
**caractérisé en ce que**
l'on prévoit le stade dans lequel on prévoit une cavité (7) de réception de la couche (8) d'arrêt de la diffusion et cela notamment par un procédé d'empreinte.

17. Procédé suivant la revendication 16,
**caractérisé en ce que**
l'on met la couche (8) d'arrêt de la diffusion dans la cavité (7) de façon à ce qu'une surface supérieure de la couche (8) d'arrêt de la diffusion soit sensiblement à affleurement avec une surface (5) supérieure de support de la couche (2) de support.

18. Procédé suivant l'une des revendications 15 à 17,
**caractérisé en ce que**
l'on dépose la couche (8) d'arrêt de diffusion sous la forme d'une couche mince sur la couche (2) de support.

19. Procédé suivant l'une des revendications 15 à 18,
**caractérisé en ce que**
l'on dépose la couche (8) d'arrêt de la diffusion par un procédé de sérigraphie ou par un procédé d'impression par jet d'encre.

20. Procédé suivant l'une des revendications 15 à 19,
**caractérisé en ce que**
l'on active le film (9) adhésif polymère par une opération de chauffage.

21. Procédé suivant l'une des revendications 15 à 20,
**caractérisé en ce que**
l'on prévoit un boîtier (20) entourant au moins en partie la couche (2) de support et/ou le composant (10) à semi-conducteurs et de fait notamment par un procédé de coulée de matières plastique.
